# EUROPÄISCHE PATENTANMELDUNG

(11) **EP 2 811 313 A1**
(43) Veröffentlichungstag der Anmeldung: **10.12.2014**
(21) Anmeldenummer: 14003013.1
(22) Anmeldetag: 30.11.2012
(51) Int. Cl.: G01R 31/36, G01R 1/20

(54) **Batteriesensor**

(62) Teilanmeldung aus: 12008049.4
(71) Anmelder: Isabellenhütte Heusler GmbH & Co.KG, 35683 Dillenburg (DE)
(72) Erfinder: Hetzler, Ullrich, 35688 Dillenburg-Oberscheld (DE)
(74) Vertreter: Beier, Ralph

(57) **Zusammenfassung**

Die Erfindung betrifft einen Batteriesensor für eine Batterie, insbesondere für eine Kraftfahrzeugbatterie, mit einer Polklemme (2) aus einem elektrisch leitfähigen Material zum elektrischen Anschluss des Batteriesensors an einen Anschlusskontakt einer Batterie, insbesondere an einen Massekontakt der Batterie, sowie mit einem niederohmigen Strommesswiderstand zur Messung eines Batteriestroms, mit dem die Batterie entladen oder geladen wird. Der erfindungsgemäße Batteriesensor umfasst weiterhin mehrere von der Polklemme (2) abstehende Zungen (8-10) zur mechanischen Halterung des Strommesswiderstands (4) an der Polklemme (2).

## Beschreibung

Die Erfindung betrifft einen Batteriesensor für eine Batterie, insbesondere für eine Kraftfahrzeugbatterie.

In modernen Kraftfahrzeugbordnetzen kann der Batteriestrom (Ladestrom bzw. Entladestrom) durch einen Batteriesensor gemessen werden, der in die Polklemme integriert ist, die an den Massepol der Kraftfahrzeugbatterie angeschlossen wird. Die eigentliche Messung des Batteriestroms erfolgt üblicherweise durch einen niederohmigen Strommesswiderstand ("Shunt"), der von dem Batteriestrom durchflossen wird, so dass der Spannungsabfall über dem niederohmigen Strommesswiderstand entsprechend dem Ohmschen Gesetz ein Maß für den Batteriestrom bildet. Beispielsweise kann ein Strommesswiderstand eingesetzt werden, wie er aus EP 0 605 800 A1 bekannt ist. Darüber hinaus kann in den Batteriesensor eine elektronische Messschaltung integriert werden, wie sie beispielsweise aus EP 1 363 131 A1 und EP 1 030 185 A2 bekannt ist.

Problematisch bei diesen bekannten Batteriesensoren ist die mechanische Belastung, die bei einer unsachgemäßen Benutzung entstehen kann, wenn beispielsweise ein Monteur die Kraftfahrzeugbatterie an dem Massekabel aus dem Montageraum herausheben möchte, da dann das gesamte Gewicht der Kraftfahrzeugbatterie von dem Batteriesensor aufgenommen werden muss.

Aus DE 10 2004 051 489 A1 und DE 10 2004 055 848 A1 sind verschiedene mögliche Bauweisen von Batteriesensoren bekannt, bei denen der niederohmige Strommesswiderstand einen einstückigen Bestandteil der Polklemme bildet oder mit der Polklemme verschweißt ist. Diese bekannten Bauweisen eines Batteriesensors sind jedoch relativ aufwendig oder mechanisch nicht hinreichend belastbar.

Der Erfindung liegt deshalb die Aufgabe zugrunde, einen entsprechend verbesserten Batteriesensor zu schaffen.

Diese Aufgabe wird durch einen erfindungsgemäßen Batteriesensor gemäß dem Hauptanspruch gelöst.

Der erfindungsgemäße Batteriesensor ist vorzugsweise für eine Kraftfahrzeugbatterie ausgelegt, jedoch eignet sich der erfindungsgemäße Batteriesensor auch für andere Batterietypen. Weiterhin ist darauf hinzuweisen, dass die Erfindung hinsichtlich der Batterie nicht auf bestimmte Batteriekapazitäten und Batteriespannungen beschränkt ist und sich grundsätzlich sowohl für aufladbare Batterien als auch für nicht wiederaufladbare Batterien eignet.

In Übereinstimmung mit dem Stand der Technik weist auch der erfindungsgemäße Batteriesensor eine Polklemme aus einem elektrisch leitfähigen Material auf, wobei die Polklemme auf einem Batteriepol der Batterie angebracht werden kann, um eine elektrische und mechanische Verbindung zwischen der Polklemme und dem Batteriepol herzustellen. Vorzugsweise wird die Polklemme im Betrieb an dem Massepol der Batterie angebracht, jedoch ist es grundsätzlich auch möglich, die Polklemme an dem Spannungspol der Batterie anzubringen.

Darüber hinaus weist auch der erfindungsgemäße Batteriesensor einen niederohmigen Strommesswiderstand zur Messung des Batteriestroms auf, wobei der Strommesswiderstand im Betrieb von dem Batteriestrom durchflossen wird, so dass der Spannungsabfall über dem niederohmigen Strommesswiderstand entsprechend dem Ohmschen Gesetz ein Maß für den Batteriestrom bildet. Beispielsweise kann im Rahmen der Erfindung ein Strommesswiderstand eingesetzt werden, wie er in EP 605 800 A1 beschrieben ist. Die Erfindung ist jedoch grundsätzlich auch mit anderen Typen von Strommesswiderständen realisierbar.

Die Erfindung sieht nun vor, dass die Polklemme mehrere von der Polklemme abstehende Zungen zur mechanischen Halterung des Strommesswiderstands aufweist. Diese Art der mechanischen Halterung des Strommesswiderstands kann gegenüber den vorstehend beschriebenen herkömmlichen Konstruktionen eine größere mechanische Belastbarkeit bieten.

Der im Rahmen der Erfindung verwendete Begriff einer Zunge umfasst vorzugsweise einen länglichen Halter, der vorzugsweise einseitig an der Polklemme angebracht oder angeformt ist. In dem bevorzugten Ausführungsbeispiel der Erfindung weisen die Zungen jeweils einen rechteckigen Querschnitt auf, jedoch sind im Rahmen der Erfindung auch Zungen mit anderen Querschnitten möglich.

Vorzugsweise sind die Zungen einstückig an die Polklemme angeformt und bestehen im Kern aus dem selben Material wie die Polklemme, was eine einfache und kostengünstige Herstellung der Polklemme mit den Zungen ermöglicht.

In einem bevorzugten Ausführungsbeispiel der Erfindung ist mindestens eine der Zungen der Polklemme nach außen elektrisch leitfähig, um ein Anschlussteil des Strommesswiderstands elektrisch zu kontaktieren, insbesondere durch eine Verschweißung oder eine Verlötung der betreffenden Zunge mit dem Anschlussteil des Strommesswiderstands. Diese Zunge hat also eine mechanische und elektrische Doppelfunktion, indem die Zunge zum einen zur mechanischen Halterung des Strommesswiderstands dient und zum anderen auch eine elektrische Kontaktierung des Strommesswiderstands bewirkt.

In dem bevorzugten Ausführungsbeispiel der Erfindung ist weiterhin mindestens eine der Zungen der Polklemme nach außen elektrisch isoliert, um einen elektrischen Kontakt dieser Zunge zu dem Strommesswiderstand zu vermeiden, da dies andernfalls zu einem elektrischen Kurzschluss über dem Strommesswiderstand führen würde. Diese elektrisch isolierte Zunge der Polklemme dient also nur zur mechanischen Halterung des Strommesswiderstands und hat ansonsten keine elektrische Kontaktierungsfunktion.

In dem bevorzugten Ausführungsbeispiel der Erfindung weist die Polklemme mindestens zwei solche elektrisch isolierte Zungen auf, die den Strommesswiderstand an der Oberseite und an der Unterseite umgreifen. Dies ist vorteilhaft, weil an dem von der Polklemme nicht kontaktierten Anschlussteil des Strommesswiderstands in der Regel ein Stromanschlusskabel angeschlossen ist, so dass an diesem Anschlussteil des Strommesswiderstands erhebliche Kräfte angreifen können. Falls die an dem freien Anschlussteil angreifenden Kräfte nach oben gerichtet sind, so werden diese Kräfte von der an der Oberseite des Strommesswiderstands angeordneten Zunge der Polklemme aufgenommen und mechanisch abgeleitet. Falls die an dem freien Anschlussteil des Strommesswiderstands angreifenden mechanischen Kräfte dagegen nach unten gerichtet sind, so werden diese Kräfte von der an der Unterseite des Strommesswiderstands angeordneten Zunge aufgenommen und abgeleitet.

Darüber hinaus weist der erfindungsgemäße Batteriesensor vorzugsweise auch eine integrierte elektronische Messschaltung auf, welche die über dem Strommesswiderstand abfallende elektrische Spannung als Maß für den Batteriestrom misst. Beispielsweise kann hierfür eine Messschaltung eingesetzt werden, wie sie in EP 1 030 185 A2 oder EP 1 363 131 A1 beschrieben ist. Die Erfindung ist jedoch hinsichtlich der Konstruktion der Messschaltung nicht auf die Messschaltungen beschränkt, die in den vorstehend genannten Druckschriften beschrieben sind.

In dem bevorzugten Ausführungsbeispiel der Erfindung weist der Batteriesensor zur Aufnahme der elektronischen Messschaltung eine Leiterplatte auf, wobei die Leiterplatte vorzugsweise direkt auf dem Strommesswiderstand angeordnet ist.

Zum einen ist diese unmittelbare Anordnung der Leiterplatte mit der Messschaltung auf dem Strommesswiderstand vorteilhaft, weil dadurch eine stabile Bauform und eine sehr niedrige Induktivität erreicht werden kann.

Zum anderen lässt sich auf diese Weise ein guter Wärmekontakt zwischen der Leiterplatte und dem Strommesswiderstand erreichen, wodurch der störende Einfluss von Thermospannungen minimiert werden kann.

In dem bevorzugten Ausführungsbeispiel der Erfindung weist die Leiterplatte an ihrer Unterseite Spannungsabgriffe auf, um die elektrische Spannung über dem Strommesswiderstand zu messen, wobei die beiden Spannungsabgriffe der Leiterplatte mit zwei Anschlussteilen des Strommesswiderstands elektrisch verbunden sind, insbesondere durch eine Verlötung. Die Messschaltung (z.B. ASIC: Application Specific Integrated Circuit) ist hierbei vorzugsweise auf der Oberseite der Leiterplatte angeordnet, jedoch ist alternativ auch eine Anordnung der Messschaltung auf der Unterseite der Leiterplatte möglich.

Die Stromversorgung des Batteriesensors und insbesondere der in den Batteriesensor integrierten Messschaltung erfolgt vorzugsweise über einen elektrischen Spannungseingang, über den eine Versorgungsspannung eingespeist wird, wobei es sich in der Regel um die Batteriespannung handelt. Darüber hinaus kann der Batteriesensor dann auch mittels der Messschaltung die Versorgungsspannung messen. Der erfindungsgemäße Batteriesensor ermöglicht also in dem bevorzugten Ausführungsbeispiel nicht nur eine Messung des Batteriestroms, sondern auch eine Messung der Batteriespannung.

Darüber hinaus weist der erfindungsgemäße Batteriesensor vorzugsweise einen Datenausgang auf, um Messwerte (z.B. Batteriestrom, Batteriespannung, etc.) über den Datenausgang ausgeben zu können.

In dem bevorzugten Ausführungsbeispiel sind der Datenausgang und der Spannungseingang in demselben Steckkontakt realisiert, wodurch die elektrische Kontaktierung des Batteriesensors vereinfacht wird.

Der Datenausgang bietet vorzugsweise einen digitalen Datenbus, wie beispielsweise einen CAN-Bus (CAN: Controller Area Network) oder einen LIN-Bus (LIN: Local Interconnect Network). Die Erfindung ist jedoch hinsichtlich der Datenstruktur an dem Datenausgang nicht auf diese Bus-Typen beschränkt, sondern auch mit anderen parallelen oder seriellen Bus-Typen realisierbar.

Ferner weist der erfindungsgemäße Batteriesensor vorzugsweise auch eine Temperaturmesseinrichtung auf, die verschiedene Temperaturen bzw. Temperaturdifferenzen messen kann.

Zum einen kann die Temperaturmesseinrichtung die Temperatur des Strommesswiderstands messen, um temperaturbedingte Schwankungen des Widerstandswerts des Strommesswiderstands bei der Messung des Batteriestroms berücksichtigen zu können. Dies ist vorteilhaft, weil bei der Berechnung des Batteriestroms entsprechend dem Ohmschen Gesetz der Widerstandswert des Strommesswiderstands als bekannt vorausgesetzt wird.

Zum anderen kann die Temperaturmesseinrichtung die Temperaturdifferenz zwischen den Anschlussteilen des Strommesswiderstands messen. Dies ist vorteilhaft, weil bei einer solchen Temperaturdifferenz eine geringfügige Thermospannung entstehen kann, welche die Spannungsmessung und damit auch die Messung des Batteriestroms verfälscht. Durch eine Messung dieser Temperaturdifferenz kann dann die Thermospannung berechnet und bei der Messung des Batteriestroms kompensatorisch berücksichtigt werden.

In dem bevorzugten Ausführungsbeispiel der Erfindung weist der Batteriesensor eine elektrisch isolierende Kunststoffummantelung auf, die den Strommesswiderstand, die Leiterplatte, die Messschaltung, den Steckkontakt, die Temperaturmesseinrichtung und/oder die Zungen der Polklemme ganz oder teilweise ummantelt.

In dem bevorzugten Ausführungsbeispiel der Erfindung dient die Kunststoffummantelung zusammen mit den Zungen zur mechanischen Halterung des Strommesswiderstands. Die Zungen erfüllen ihre mechanische Stabilisierungsfunktion dann also nur in Verbindung mit der Kunststoffummantelung. Die Zungen selbst müssen also nicht unmittelbar an dem Strommesswiderstand anliegen, um den Strommesswiderstand halten zu können. Es besteht jedoch im Rahmen der Erfindung auch die Möglichkeit, dass die Zungen direkt an dem Strommesswiderstand anliegen und den Strommesswiederstand deshalb unabhängig von der Kunststoffummantelung mechanisch halten.

Diese Kunststoffummantelung besteht vorzugsweise aus einem Duroplast, was aus verschiedenen Gründen vorteilhaft ist. Zum einen haftet Duroplast gut auf Metall, wodurch die Herstellung vereinfacht wird. Zum anderen ist Duroplast feuchtedicht auch an Übergangsstellen zwischen dem Duroplast und dem Metall des Strommesswiderstands. Ein weiterer Vorteil von Duroplast als Material für die Kunststoffummantelung besteht darin, dass der thermische Ausdehnungskoeffizient von Duroplast an den thermischen Ausdehnungskoeffizient von Metall angepasst ist, so dass bei Temperaturänderungen keine thermischen Probleme entstehen. Darüber hinaus ist Duroplast auch mechanisch belastbarer als andere Kunststoffe, wodurch die mechanische Belastbarkeit des erfindungsgemäßen Batteriesensors weiter verbessert wird. Weiterhin ist Duroplast beim Umspritzen äußerst dünnflüssig und schädigt elektronische Bauelemente nicht, was beispielsweise bei Thermoplasten nicht der Fall ist. Schließlich ermöglicht Duroplast eine einfache Herstellung, indem die Kunststoffummantelung einfach umspritzt wird.

Die Erfindung ist jedoch hinsichtlich des Materials der Kunststoffummantelung nicht auf Duroplast beschränkt, sondern grundsätzlich auch mit anderen Kunststoffen realisierbar, die vorzugsweise thermisch leitfähig sind und vorzugsweise das gleiche Wärmeausdehnungsverhalten aufweisen wie die Leiterplatte, der Strommesswiderstand und/oder die Messschaltung.

Ferner ist zu erwähnen, dass der Strommesswiderstand in dem bevorzugten Ausführungsbeispiel mit einem seiner beiden plattenförmigen Anschlussteile teilweise aus der Kunststoffummantelung herausragt und mit dem herausragenden Teil einen Stromanschluss bildet, um den Batteriestrom einzuleiten oder auszuleiten.

Weiterhin ist zu erwähnen, dass die Erfindung nicht auf dem vorstehend beschriebenen erfindungsgemäßen Batteriesensor als einzelnes Bauteil beschränkt ist, sondern auch eine Batterie umfasst, auf der ein erfindungsgemäßer Batteriesensor montiert ist.

Andere vorteilhafte Weiterbildungen der Erfindung sind in den Unteransprüchen gekennzeichnet oder werden nachstehend zusammen mit der Beschreibung des bevorzugten Ausführungsbeispiels der Erfindung anhand der Figuren näher erläutert. Es zeigen:

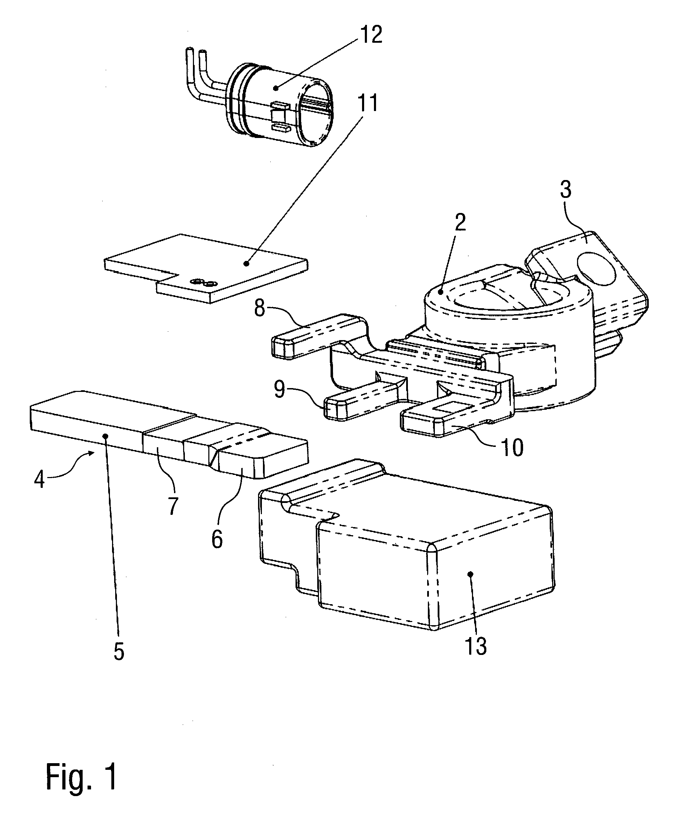

- Figur 1: eine Explosionsdarstellung eines erfindungsgemäßen Batteriesensors,
- Figur 2A: eine Perspektivansicht einer Polklemme des erfindungsgemäßen Batteriesensors,
- Figur 2B: eine Perspektivansicht der Polklemme gemäß Figur 2 mit dem darin bereits montierten Strommesswiderstand,
- Figur 2C: eine Perspektivansicht eines weiteren Montageschrittes mit der auf dem Strommesswiderstand bereits angeordneten Leiterplatte mit einer Messschaltung,
- Figur 2D: einen weiteren Montageschritt mit einem an die Leiterplatte angeschlossenen Steckkontakt, sowie
- Figur 2E: eine Perspektivansicht eines fertig montierten erfindungsgemäßen Batteriesensors.

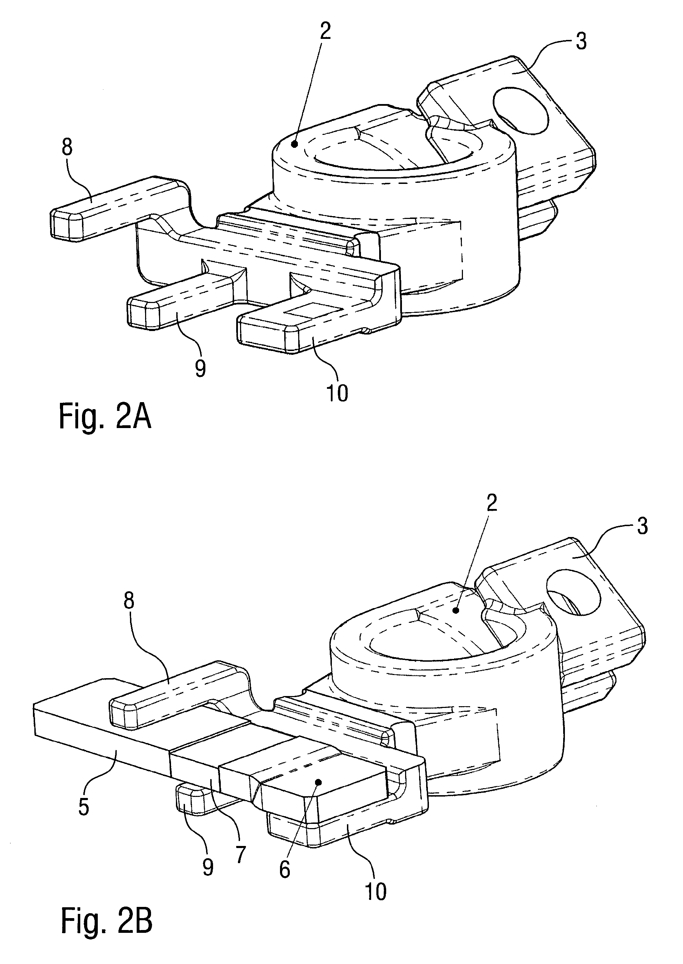

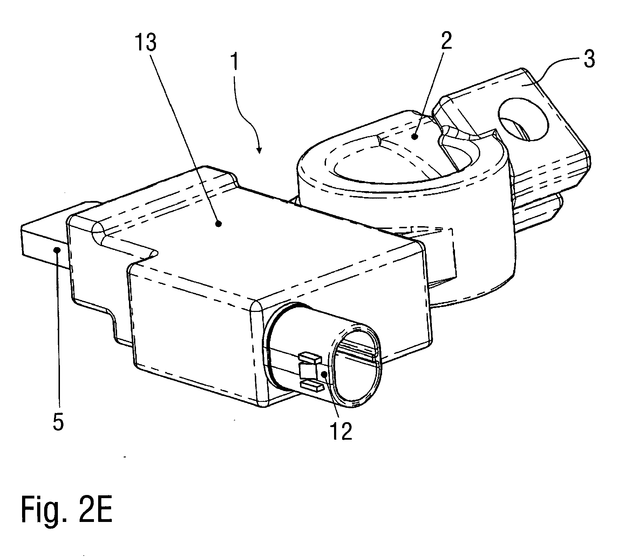

Die Zeichnungen zeigen einen erfindungsgemäßen Batteriesensor 1 (vgl. Figur 2E), der zur Messung des Batteriestroms (Ladestrom oder Entladestrom) bei einer herkömmlichen Kraftfahrzeugbatterie eingesetzt werden kann.

Hierzu weist der Batteriesensor 1 eine Polklemme 2 auf, die zur Messung des Batteriestroms auf den Massepol der Kraftfahrzeugbatterie aufgesteckt und dann mittels eines Schraubflanschs 3 an dem Massepol befestigt wird, wodurch eine elektrische und mechanische Verbindung zwischen der Polklemme 2 und dem Massepol der Kraftfahrzeugbatterie hergestellt wird.

Die Messung des Batteriestroms erfolgt gemäß der bekannten Vierleitertechnik mittels eines niederohmigen Strommesswiderstands 4, wobei der Strommesswiderstand 4 in herkömmlicher Weise ausgebildet sein kann, wie beispielsweise in EP 0 605 800 A1 beschrieben ist. So weist der Strommesswiderstand 4 zwei plattenförmige Anschlussteile 5, 6 aus einem Leitermaterial (z.B. Kupfer oder ein Kupferlegierung) und ein ebenfalls plattenförmiges Widerstandselement 7 aus einer niederohmigen Widerstandslegierung (z.B. Manganin®) auf, wobei das Widerstandselement 7 im Strompfad zwischen den beiden Anschlussteilen 5, 6 angeordnet ist, so dass der Batteriestrom über die beiden Anschlussteile 5, 6 in den Strommesswiderstand eingeleitet bzw. daraus abgeleitet wird und durch das niederohmige Widerstandselement 7 fließt. Der Spannungsabfall über dem niederohmigen Widerstandselement 7 entspricht also entsprechend dem Ohmschen Gesetz dem Batteriestrom, der durch den Strommesswiderstand 4 fließt.

Zur mechanischen Halterung des Strommesswiderstands 4 an der Polklemme 2 weist die Polklemme 2 drei Zungen 8, 9, 10 auf, die einstückig an die Polklemme 2 angeformt sind und parallel zueinander seitlich von der Polklemme 2 abstehen.

Die Zunge 10 dient hierbei nicht nur zur mechanischen Halterung des Strommesswiderstands 4, sondern auch zur elektrischen Kontaktierung des Anschlussteils 6 des Strommesswiderstands 4, wie insbesondere aus Figur 2B ersichtlich ist. So ist das Anschlussteil 6 des Strommesswiderstands 4 im montierten Zustand durch eine Lötverbindung mit der Zunge 10 der Polklemme 2 verbunden. Zur Ermöglichung dieser elektrischen Kontaktierung besteht die Polklemme 2 und damit auch die Zunge 10 aus einem elektrischen leitfähigen Material (z.B. Messing), wobei die Zunge 10 nach außen nicht isoliert ist, um die elektrische Kontaktierung des Anschlussteils 6 zu ermöglichen. Die Zunge 10 hat also in diesem Ausführungsbeispiel eine Doppelfunktion. Zum einen stützt die Zunge 10 den Strommesswiderstand 4 unterhalb des Anschlussteils 6 ab und dient somit zur mechanischen Halterung des Strommesswiderstands 4. Zum anderen dient die Zunge 10 aber auch zur elektrischen Kontaktierung des Strommesswiderstands 4.

Die beiden anderen Zungen 8, 9 der Polklemme 2 dienen dagegen ausschließlich zur mechanischen Halterung des Strommesswiderstands 4. So stützt die Zunge 9 den Strommesswiderstand 4 an dessen Unterseite ab, während die andere Zunge 8 an der Oberseite des Strommesswiderstands 4 aufliegt, so dass die beiden Zungen 8, 9 den Strommesswiderstand 4 an der Oberseite bzw. an der Unterseite umgreifen.

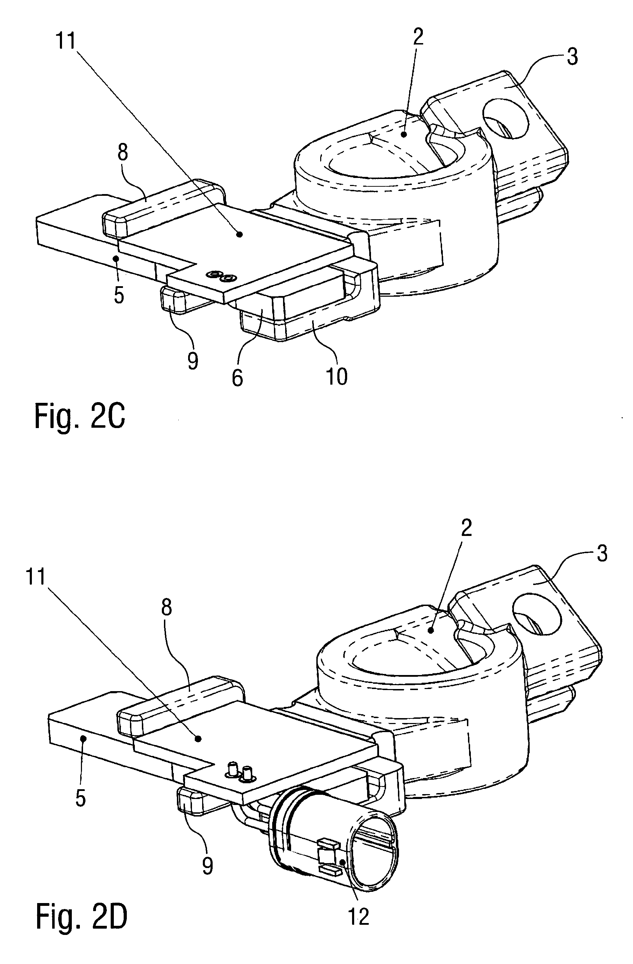

Aus den Figuren 2C und 2D ist weiterhin ersichtlich, dass an der Oberseite des Strommesswiderstands eine Leiterplatte 11 mit einer Messschaltung (nicht dargestellt) angeordnet ist, wobei die Leiterplatte 11 an ihrer Unterseite zwei Spannungsabgriffe aufweist, die durch eine Lötverbindung mit den beiden Anschlussteilen 5, 6 des Strommesswiderstands 4 verbunden sind, so dass die Spannungsabgriffe der Leiterplatte 11 den Spannungsabfall über dem Widerstandselement 7 messen. Die auf der Oberseite der Leiterplatte 11 angeordnete Messschaltung ist über entsprechende Leiterbahnen mit diesen beiden Spannungsabgriffen verbunden und misst also den Spannungsabfall über dem Widerstandselement 7 des Strommesswiderstands 4. Darüber hinaus weist die Leiterplatte 11 auch einen nicht dargestellten Massekontakt auf.

Ferner weist der erfindungsgemäße Batteriesensor 1 einen Steckkontakt 12 auf, der zwei Funktionen hat.

Zum einen wird über den Steckkontakt 12 die Batteriespannung der Kraftfahrzeugbatterie zugeführt, die von der auf der Leiterplatte 11 angeordneten Messschaltung ebenfalls gemessen wird und auch zur Stromversorgung des Batteriesensors 1 dient.

Zum anderen enthält der Steckkontakt 12 aber auch einen Datenausgang in Form eines CAN-Buses (CAN: Controller Area Network) oder eines LIN-Buses (LIN: Local Interconnect Network), um die von der Messschaltung gemessenen Daten ausgeben zu können.

Von besonderer Bedeutung ist weiterhin eine Kunststoffummantelung 13 aus Duroplast, die den Strommesswiderstand 4, die Zungen 8-10, die Leiterplatte 11 und den Innenbereich des Steckkontakts 12 ummantelt.

Zum einen dient die Kunststoffummantelung zur elektrischen Isolierung und zur hermetischen Abdichtung des Batteriesensors 1 nach außen.

Zum anderen dient die Kunststoffummantelung 13 aber auch zur mechanischen Stabilisierung des Batteriesensors 1. So ragt das Anschlussteil 5 des Strommesswiderstands 4 aus der Kunststoffummantelung 13 heraus, so dass die an dem Anschlussteil 5 angreifenden mechanischen Kräfte nicht nur von den beiden Zungen 8, 9 aufgenommen werden, sondern auch von der Kunststoffummantelung 13, die somit ebenfalls zur mechanischen Stabilisierung beiträgt. Darüber hinaus füllt die Kunststoffummantelung 13 den Zwischenraum zwischen den Zungen 8, 9 einerseits und dem Strommesswiderstand 4 andererseits aus, so dass die Zungen 8, 9 den Strommesswiderstand 4 mechanisch stabilisieren können.

Ferner ist zu erwähnen, dass die auf der Leiterplatte 11 angeordnete Messschaltung auch die Temperaturdifferenz zwischen den beiden Anschlussteilen 5, 6 des Strommesswiderstands 4 misst. Dies ist vorteilhaft, da auf diese Weise Thermospannungen kompensiert werden können, die aufgrund einer Temperaturdifferenz zwischen den beiden Anschlussteilen 5, 6 des Strommesswiderstands entstehen.

Weiterhin misst die auf der Leiterplatte 11 angeordnete Temperaturmesseinrichtung auch die Temperatur des Strommesswiderstands 4. Dies ist sinnvoll, weil der Widerstandswert des Widerstandselements 7 des Strommesswiderstands 4 mit der Temperatur geringfügig schwankt. Durch eine Messung der Temperatur des Widerstandselements 7 können diese temperaturbedingten Schwankungen des Widerstandswerts bei der Messung des Batteriestroms ebenfalls berücksichtigt und kompensiert werden.

Die Erfindung ist nicht auf das vorstehend beschriebene bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen. Darüber hinaus beansprucht die Erfindung auch Schutz für den Gegenstand und die Merkmale der Unteransprüche unabhängig von den Merkmalen der in Bezug genommenen Ansprüche. So genießt beispielsweise der Gedanke einer Kunststoffummantelung im Rahmen der Erfindung eigene schutzwürdige Bedeutung.
- 1: Batteriesensor
- 2: Polklemme
- 3: Schraubflansch
- 4: Strommesswiderstand
- 5: Anschlussteil
- 6: Anschlussteil
- 7: Widerstandselement
- 8: Zunge
- 9: Zunge
- 10: Zunge
- 11: Leiterplatte
- 12: Steckkontakt
- 13: Kunststoffummantelung

## Patentansprüche

1. Batteriesensor (1) für eine Batterie, insbesondere für eine Kraftfahrzeugbatterie, mit
a) einer Polklemme (2) aus einem elektrisch leitfähigen Material zum elektrischen Anschluss des Batteriesensors (1) an einen Anschlusskontakt einer Batterie, insbesondere an einen Massekontakt der Batterie,
b) einem niederohmigen Strommesswiderstand (4) zur Messung eines Batteriestroms, mit dem die Batterie entladen oder geladen wird,
c) mehreren von der Polklemme (2) abstehenden Zungen (8-10) zur mechanischen Halterung des Strommesswiderstands (4) an der Polklemme (2), und
d) einer Temperaturmesseinrichtung,
**dadurch gekennzeichnet,**
e) **dass** die Temperaturmesseinrichtung in Abhängigkeit von einer gemessenen Temperaturdifferenz über dem Strommesswiderstand (4) eine über dem Strommesswiderstand (4) abfallende Thermospannung berechnet und die Thermospannung bei der Messung des Batteriestroms berücksichtigt.

2. Batteriesensor (1) nach Anspruch 1, **dadurch gekennzeichnet, dass** die Zungen (8-10) einstückig an die Polklemme (2) angeformt sind.

3. Batteriesensor (1) nach einem der vorhergehenden Ansprüche, **dadurch gekennzeichnet, dass** mindestens eine der Zungen (10) der Polklemme (2) nach außen elektrisch leitfähig ist, um ein Anschlussteil (6) des Strommesswiderstands (4) elektrisch zu kontaktieren, insbesondere durch eine Verschweißung oder eine Verlötung der Zunge mit dem Anschlussteil des Strommesswiderstands (4).

4. Batteriesensor (1) nach einem der vorhergehenden Ansprüche, **dadurch gekennzeichnet,**
a) **dass** mindestens eine der Zungen (8-10) der Polklemme (2) nach außen elektrisch isoliert ist, um einen elektrischen Kontakt zu dem Strommesswiderstand (4) zu vermeiden, und/oder
b) **dass** zwei Zungen (8, 9) der Polklemme (2) nach außen elektrisch isoliert sind und den Strommesswiderstand (4) an dessen Oberseite und an dessen Unterseite umgreifen.

5. Batteriesensor (1) nach einem der vorhergehenden Ansprüche, **gekennzeichnet durch** eine elektronische Messschaltung zur Messung einer über dem Strommesswiderstand (4) abfallenden elektrischen Spannung als Maß für den Batteriestrom.

6. Batteriesensor (1) nach Anspruch 5, **dadurch gekennzeichnet,**
a) **dass** zur Aufnahme der elektronischen Messschaltung eine Leiterplatte (11) vorgesehen ist, und/oder
b) **dass** die Leiterplatte (11) direkt auf dem Strommesswiderstand (4) angeordnet ist, und/oder
c) **dass** die Leiterplatte (11) an ihrer Unterseite Spannungsabgriffe aufweist, um die elektrische Spannung über dem Strommesswiderstand (4) zu messen, wobei die beiden Spannungsabgriffe der Leiterplatte (11) mit zwei Anschlussteilen des Strommesswiderstands (4) elektrisch verbunden sind, insbesondere durch eine Verlötung, und/oder
d) **dass** die Messschaltung auf der Oberseite der Leiterplatte (11) angeordnet ist.

7. Batteriesensor (1) nach einem der Ansprüche 5 oder 6, **gekennzeichnet durch**
a) dass der Batteriesensor (1) einen elektrischen Spannungseingang aufweist zur Einspeisung einer Versorgungsspannung, und/oder
b) dass die Messschaltung von der über den Spannungseingang zugeführten Versorgungsspannung mit elektrischer Energie versorgt wird, und/oder
c) dass die Messschaltung zusätzlich zu dem Batteriestrom auch die über den Spannungseingang zugeführte Versorgungsspannung misst.

8. Batteriesensor (1) nach einem der vorhergehenden Ansprüche, **dadurch gekennzeichnet,**
a) **dass** der Batteriesensor (1) zur Ausgabe von Messwerten einen Datenausgang aufweist, und/oder
b) **dass** der Datenausgang und der Spannungseingang in demselben Steckkontakt (12) realisiert sind, und/oder
c) **dass** der Datenausgang einen digitalen Datenbus bietet, insbesondere einen CAN-Bus oder einen LIN-Bus.

9. Batteriesensor (1) nach einem der vorhergehenden Ansprüche, **dadurch gekennzeichnet, dass** die Messschaltung in Abhängigkeit von der gemessenen Temperatur des Strommesswiderstands (4) eine thermisch bedingte Widerstandsänderung berechnet und die thermisch bedingte Widerstandsänderung bei der Messung des Batteriestroms berücksichtigt.

10. Batteriesensor (1) nach einem der vorhergehenden Ansprüche, **gekennzeichnet durch** eine elektrisch isolierende Kunststoffummantelung (13), die den Strommesswiderstand (4), die Leiterplatte (11), die Messschaltung, den Steckkontakt (12), die Temperaturmesseinrichtung und/oder die Zungen (8-10) der Polklemme (2) ummantelt.

11. Batteriesensor (1) nach Anspruch 10,
**dadurch gekennzeichnet,**
a) **dass** die Kunststoffummantelung (13) aus einem Duroplast besteht, und/oder
b) **dass** der Strommesswiderstand (4), die Leiterplatte (11), die Messschaltung, der Steckkontakt (12), die Temperaturmesseinrichtung und/oder die Zungen (8-10) der Polklemme (2) mit dem Duroplast umspritzt sind, und/oder
c) **dass** die Kunststoffummantelung (13) aus einem Kunststoff besteht, der im Wesentlichen das gleiche Wärmeausdehnungsverhalten aufweist wie die Leiterplatte (11) und/oder die Messschaltung, und/oder
d) **dass** die Kunststoffummantelung (13) aus einem Kunststoff besteht, der thermisch leitfähig ist, und/oder
e) **dass** der Strommesswiderstand (4) mit einem seiner beiden Anschlussteile teilweise aus der Kunststoffummantelung (13) heraus ragt und mit dem heraus ragenden Teil einen Stromanschluss bildet, um den Batteriestrom einzuleiten oder auszuleiten.

12. Batteriesensor (1) nach einem der vorhergehenden Ansprüche, **dadurch gekennzeichnet,**
a) **dass** der Strommesswiderstand (4) ein erstes plattenförmiges Anschlussteil (6) aus einem Leitermaterial und ein zweites plattenförmiges Anschlussteil (5) aus dem Leitermaterial aufweist,
b) **dass** der Strommesswiderstand (4) ein plattenförmiges Widerstandselement (7) aus einer Widerstandslegierung aufweist,
c) **dass** das Widerstandselement (7) im Strompfad zwischen den beiden Anschlussteilen (5, 6) angeordnet ist,
d) **dass** das Leitermaterial einen kleineren spezifischen elektrischen Widerstand aufweist als die Widerstandslegierung.

13. Batteriesensor (1) nach Anspruch 12,
**dadurch gekennzeichnet,**
a) **dass** eine erste Zunge (10) der Polklemme (2) das erste Anschlussteil (6) des Strommesswiderstands (4) von unten mechanisch abstützt,
b) **dass** die erste Zunge (10) der Polklemme (2) das erste Anschlussteil (6) des Strommesswiderstands (4) elektrisch kontaktiert,
c) **dass** das zweite Anschlussteil (5) des Strommesswiderstands (4) einen Stromanschluss bildet, um den Batteriestrom einzuleiten oder auszuleiten,
d) **dass** eine zweite Zunge (9) der Polklemme (2) den Strommesswiderstand (4) von unten abstützt,
e) **dass** eine dritte Zunge (8) der Polklemme (2) den Strommesswiderstand (4) von oben abstützt,
f) **dass** die zweite Zunge (9) und die dritte Zunge (8) der Polklemme (2) nach außen elektrisch isolierend sind, um eine elektrische Kontaktierung des. Strommesswiderstands (4) zu vermeiden,
g) **dass** die zweite Zunge (9) und die dritte Zunge (8) den Strommesswiderstand (4) zwischen den beiden Anschlussteilen (5, 6) abstützen, um eine mechanische Belastung an dem als Stromanschluss dienenden zweiten Anschlussteil (5) aufzunehmen.

14. Batterie, insbesondere Kraftfahrzeugbatterie, mit zwei Anschlusskontakten, **dadurch gekennzeichnet, dass** ein Batteriesensor (1) nach einem der vorhergehenden Ansprüche an einem der Anschlusskontakte angebracht ist, insbesondere an einem Massepol der Batterie.
